# EUROPEAN PATENT SPECIFICATION

(11) **EP 0 665 599 B1**
(45) Date of publication and mention of the grant of the patent: **27.05.1998**
(21) Application number: 94922273.1
(22) Date of filing: 29.07.1994
(51) Int. Cl.: H01L 33/00, H01L 25/075

(54) **LIGHTING DEVICE BY INFRARED RADIATION**
Infrarot-Beleuchtungseinrichtung
DISPOSITIF D'ECLAIRAGE PAR INFRAROUGES

(30) Priority: 30.07.1993 ES 9302145 U
(43) Date of publication of application: 02.08.1995
(73) Proprietor: TAU PROMOCIONES, S.A., 28013 Madrid (ES)
(72) Inventor: BAQUERO MOCHALES, Macario, E-28038 Madrid (ES)
(74) Representative: Winkler, Andreas, Dr.
(86) International application number: ES9400076
(87) International publication number: WO9504376

(56) References cited:
- DE-C- 3 622 025
- DE-U- 8 815 418
- PATENT ABSTRACTS OF JAPAN vol. 8, no. 264 (E-282) (1701) 4 December 1984 & JP-A-59 134 883

## Description

The present invention refers to an infrared light emitting device according to the preamble of claim 1, and its object is a lighting device acting by means of radiation occupying a region in the luminous electromagnetic spectrum which covers from the limit of visible light, beyond visible red, to that of longer wavelength Hertz waves known as infrared radiation.

In the state of the art referring to this invention, various anticipations of infrared lighting units are already known, since this art offers notable advantages in its use, particularly when seeking illumination which does not annoy or is not even visible. At the same time, infrared lighting enables the human being to obtain a much broader, truer and more complete perception of reality than he can achieve with his own senses alone. By applying infrared radiation and using the due analysis instrument, he can see the energy reflected by the object or being under study on applying a beam of luminous radiation thereto which undergoes an absorption/reflection transformation in the body in question.

Development of the infrared illumination art was mainly centred on the use of higher powered spotlights provided with a filter which only allow infrared light to penetrate. The disadvantage is a considerable loss of light and calorific energy.

A subsequent step taken in this sphere of the art to overcome such disadvantages is the application of commercial semiconductor diodes which transform electric energy into light in the infrared, spectrum.

An infrared light emitting device according to the preamble of claim is known from DE 88 15 418 U1 according to which the metallic dissipators are integrally formed as a heat sink with the base support on one side of the plate and the light emitting diodes (LEDs) being covered by an external protector are arranged on the other side of the plate. This structure is quite complicated and expensive, especially due to the fact that in the case of the breakdown of one dissipating fin the whole dissipation section together with the base support has to be exchanged and due to the existance of the external protection. The external protection, however, can be broken or scratched and suffers wear and tear over time, causes loss of radiated energy and prevents heat removal leading to overheating problems.

Thus, the problem of the invention is to improve the infrared light emitting device according to the preamble of claim 1 such that it overcomes the problems of the prior art, especially has a simple structure, minimizes losses of radiated energy and overheating problems as well as reduces manufacture and repair costs.

This problem is solved by an infrared light emitting device according to claim 1.

A preferred embodiment of the invention is described in claim 2.

The present infrared light emitting device is an advance in improving infrared lighting devices since it provides significant advantages which can be fully appreciated in their use and manufacture.

Due to its design characteristics, the device being claimed later herein provides notable advantages over known devices, in contrast to conventional spotlights. It is smaller in size than traditional units mainly due to having its dissipator in front, in the emission area. This also gives advantages in its application.

The positional versatility of the infrared light emitting device being claimed is to be noted. Its smaller size and, thus, smaller weight, allow it to be adapted to the receiving unit as a portable item.

The object being presented allows for the shape most suited to the use to which it is earmarked. It is also very hard and resistant to knocks, whether accidental or deliberate beyond ordinary use.

Amongst the advantages of this invention is its adaptability to requirements of use as far as varying light emission is concerned. Such is achieved by changing either the supply voltage or with the number of diodes or even panels holding them without harming operating safety. This is due to an increase in light intensity and calorific energy being offset by the easy adaptation of the device to large metal areas, by its forced ventilation or any other known system for such purpose although it will suffice to bear in mind that with diodes fitted into the base support, the larger the number of infrared diodes, the larger the area required. At the same time, however, this also provides an increase in the cooling capability.

A further advantage of the device in question compared to earlier ones in the sector and the state of the art involved is that it can be used in the open due to its mechanical layout and the technology and components used, particularly semiconductor diodes, and its leak-tight quality. It can dispense with conventional external protectors such as plastic or glass which cause a loss of radiated energy and prevent heat removal thus causing overheating problems. Such protectors can also be scratched or broken and, of course, suffer wear and tear over time.

The overall unit is very hard due to its structure formed by an aluminium support-box, metal dissipator sections whose cross section is a right angled "U" also of aluminium or even brass, iron, etc., protruding above the infrared diodes and their printed circuit support embedded in resin. This construction means that certain types of blow which would put other units out of service would only slightly harm the operability of the claimed device. This was demonstrated in experiments performed by the inventor in which it was seen that a bullet hole not exceeding 10% of the total infrared light emitting area would only cause an approximate 30% loss of operability.

The maintenance cost for the infrared light emitting device according to te invention is low. It gains over anything known since a lamp in a typical state of the art spotlight lasts about 500 hours meaning a high replacement cost. Such lamps usually fail during operation leaving the receiving unit with which it is combined out of service at a possibly crucial moment. On the other hand, the present infrared light emitting device has a practically unlimited life thus preventing the aforementioned untimely failures of their components since, even though several semiconductor diodes were to fail at the same time, this lighting device would continue operating.

The advantages mentioned, particularly those appreciable in its use, make the infrared light emitting device presented most attractive in night vision activities typical of guarding and security firms rendering services in banks, official institutions and companies using closed circuit television cameras requiring the use of infrared spotlights.

Likewise, various public agencies such as the police, army and even health will benefit from the qualities of the present infrared light emitting device. Its application in the health sphere refers to watching over the sick and children who cannot withstand continuous light, and in the treatment of dermatological illnesses using in-infrared light beams, due to the capability of varying the intensity of the light beam provided by the device being claimed.

Advantages in the manufacture of the claimed device include its ease in assembly due to the use of a printed circuit as a support in fibre glass or bakelite. This allows for very accurate construction and immediate connection of the infrared diodes which will be a combination of series and parallel connections. The LEDs will thus be arranged in groups, each of which is connected in parallel and then together in series. Such arrangement may be selected as a function of the power source since, in some cases, it may be suitable to apply high voltages where series connection will be preferable whilst parallel connection may be advisable in cases of low supply voltages, without suffering the problem of short-circuiting through polarity reversal since diodes do not conduct in reverse.

In commenting on the functional advantages characterizing this invention, its design and configuration were mentioned. However, for further clarification, the claimed infrared light emitting device consists of a basic support body in a preferably rectangular box shaped structure, although any other shape may be adopted depending on the use to which the device is intended. The base has a printed circuit plate fitted on which successive, conventional, alternate, parallel rows of right angled. "U" cross sectioned metal dissipator sections are mounted and secured by conventional means. Such sections are higher than the LED's which are arranged in rows alternating with the aforesaid metal dissipator sections. The whole forms a compact unit when an approximately 2 mm. thick layer of resin is applied to protect and insulate the said circuit providing the whole device with a small perimeter lip.

To facilitate understanding of the foregoing, one form of a practical embodiment of the present infrared light emitting device is shown in the attached drawings, as an example but not limiting.

Figure 1 shows a partial cross section view of the device with the succession of alternate, right angled "U" cross sectioned rows of metal dissipater sections and semiconductor diodes.

Figure 2 also partially shows a plan view of the device being presented.

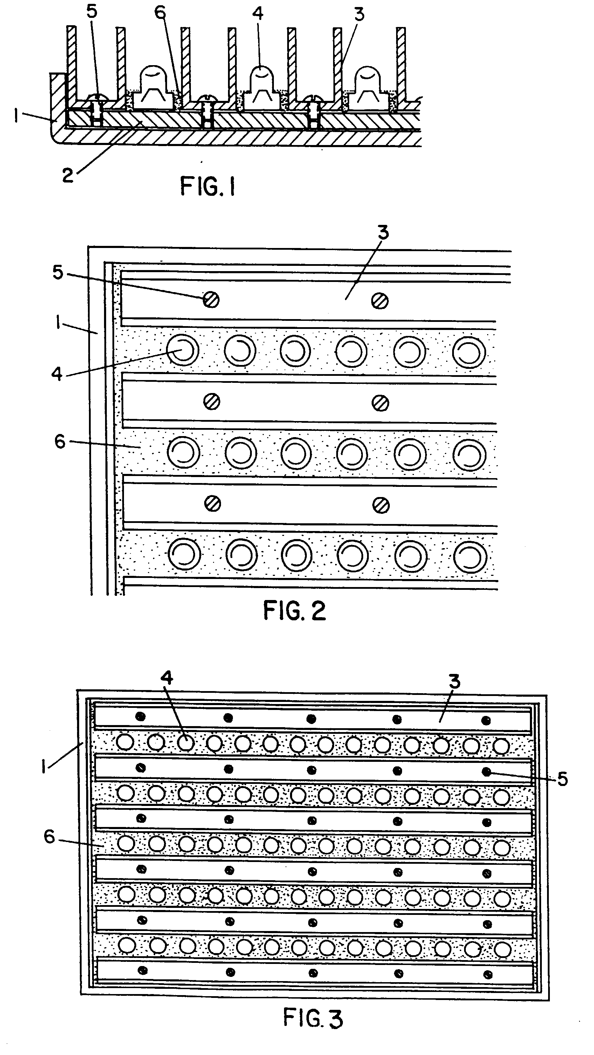

Finally, Figure 3 shows a complete plan view of the device claimed, in this specific case adopting a rectangular shape, ready for use.

All Figures show the box-shaped, basic plate, 1, preferably rectangular but adaptable to any other shape configuration, provided with a perimeter lip, on which the printed circuit plate, 2, is arranged. This, in turn, bears the rows of metal, right angled "U" cross sectioned dissipator sections, 3, which alternate with the rows of semiconductor diodes, 4, connected together. The metal sections are slightly higher than the diodes. The rows of metal dissipator sections are secured to the printed circuit plate by screws, 5, or any other conventional means. Both types of row are protected and insulated by a layer of resin, 6, applied in an approximate thickness of 2 mm, covering the whole unit.

The foregoing faithfully describes the invention which is the subject of this application without irrelevant variation in shape, circumstances and accessories not impairing its essential nature claimed hereafter.

## Claims

1. Infrared light emitting device comprising:
- a box-shaped base support (1),
- a plate (2) having a printed circuit and being connected to the base support (1),
- a plurality of semiconductor infrared light emitting diodes (4) being connected via said printed circuit of the plate (2), and
- a plurality of metal dissipators (3) having a right angled U-shaped cross section,
characterized in that
- the diodes (4) and the dissipators (3) are mounted on the same side of the plate (2), the dissipators (3) rising above the diodes (4),
- the diodes (4) are arranged in parallel rows,
- the dissipators (3) are arranged in parallel, alternating with said rows of diodes (4),
- an approximately 2mm thick resin layer (6) is provided in the rows of diodes (4) protecting and insulating the junction between each row of diodes (4) and the respective adjacent rows of dissipators (3), and
- the base support side walls surround the diodes (4) and the dissipators (3), at least over a part of their respective heights perpendicular to the plate (2), forming lips to protect the printed circuit plate (2) and the resin layer (6), ensuring a solid and compact unit.

2. Infrared light emitting device according to claim 1, characterized in that
- the diodes (4) of each row are connected in parallel, and
- the rows of diodes (4) are connected in series.

## Patentansprüche

1. Infrarotlicht abstrahlende Vorrichtung, welche umfaßt:
- einen kastenartigen Grundträger (1),
- eine Platte (2), die eine gedruckte Schaltung aufweist und mit dem Grundträger (1) verbunden ist,
- mehrere Infrarotlicht abstrahlende Halbleiterdioden (4), die über besagte gedruckte Schaltung der Platte (2) verbunden sind, und
- mehrere Metall-Kühlelemente (3) mit einem rechtwinkligen U-förmigen Querschnitt,
dadurch gekennzeichnet, daß
- die Dioden (4) und die Kühlelemente (3) auf derselben Seite der Platte (2) angebracht sind, wobei die Kühlelemente (3) über die Dioden (4) hinausragen,
- die Dioden (4) in parallelen Reihen angeordnet sind,
- die Kühlelemente (3) parallel angeordnet sind, alternierend mit besagten Reihen von Dioden (4),
- eine ungefähr 2 mm dicke Harzschicht (6) in den Reihen von Dioden (4) vorgesehen ist, welche den Übergang zwischen jeder Reihe von Dioden (4) und den entsprechenden angrenzenden Reihen von Kühlelemente (3) schützt und isoliert, und
- die Grundträger-Seitenwände die Dioden (4) und die Kühlelemente (3) umgeben, wobei sie, wenigstens über einen Teil ihrer entsprechenden Höhe senkrecht zur Platte (2), Lippen bilden, um die Platte mit der gedruckten Schaltung (2) und die Harzschicht (6) zu schützen, um eine stabile und kompakte Einheit zu gewährleisten.

2. Infrarotlicht abstrahlende Einrichtung nach Anspruch 1, dadurch gekennzeichnet, daß
- die Dioden (4) jeder Reihe parallel geschaltet sind und
- die Reihen von Dioden (4) in Reihe geschaltet sind.

## Revendications

1. Dispositif d'émission de lumière infra-rouge comprenant :
- une base support en forme de boîte (1),
- une plaque (2) ayant un circuit imprimé et connectée à la base support (1),
- une pluralité de diodes semi-conductrices d'émission de lumière infra-rouge connectées via ledit circuit imprimé de la plaque (2), et
- une pluralité de dissipateurs en métal (3) ayant une section transversale en forme de U à angles droits,
caractérisé par le fait que
- les diodes (4) et les dissipateurs (3) sont montés sur le même côté de la plaque (2), les dissipateurs (3) s'élevant au-dessus des diodes (4),
- les diodes (4) sont disposées en rangées parallèles,
- les dissipateurs (3) sont disposés en parallèle, en alternance avec lesdites rangées de diodes (4),
- une couche de résine (6) d'environ 2 mm d'épaisseur est prévue dans les rangées de diodes (4) protégeant et isolant la jonction entre chaque rangée de diodes (4) et les rangées adjacentes respectives de dissipateurs (3), et
- les parois latérales de la base-support (1) entourent les diodes (4) et les dissipateurs (3), au moins sur une partie de leurs hauteurs respectives perpendiculaires à la plaque (2), en formant des lèvres pour protéger la plaque de circuit imprimé (2) et la couche de résine (6), garantissant une unité compacte et solide.

2. Dispositif d'émssion de lumière infra-rouge selon la revendication 1, caractérisé par le fait que :
- les diodes (4) de chaque rangée sont connectées en parallèle, et
- les rangées de diodes (4) sont connectées en série.
